# EUROPÄISCHE PATENTSCHRIFT

(11) **EP 1 425 754 B1**
(45) Veröffentlichungstag und Bekanntmachung des Hinweises auf die Patenterteilung: **26.10.2005**
(21) Anmeldenummer: 02760131.9
(22) Anmeldetag: 26.08.2002
(51) Int. Cl.: G11C 11/16

(54) **KOMPENSATION EINES MAGNETISCHEN BIASFELDES IN EINER SPEICHERSCHICHT EINER MAGNETORESISTIVEN SPEICHERZELLE**
COMPENSATION OF A BIAS MAGNETIC FIELD IN A STORAGE SURFACE OF A MAGNETORESISTIVE STORAGE CELL
COMPENSATION D'UN CHAMP MAGNETIQUE POLARISE DANS UNE SURFACE DE MEMOIRE D'UNE CELLULE DE MEMOIRE MAGNETORESISTANTE

(30) Priorität: 31.08.2001 DE 10142594
(43) Veröffentlichungstag der Anmeldung: 09.06.2004
(73) Patentinhaber: Infineon Technologies AG, 81669 München (DE)
(72) Erfinder: Bangert, Joachim, 91052 Erlangen (DE)
(74) Vertreter: Kottmann, Heinz Dieter
(86) Internationale Anmeldenummer: PCT/DE2002/003120
(87) Internationale Veröffentlichungsnummer: WO 2003/025945

(56) Entgegenhaltungen:
- DE-A- 10 103 314
- US-A1- 2002 176 277
- PATENT ABSTRACTS OF JAPAN vol. 1999, no. 13, 30. November 1999 (1999-11-30) & JP 11 238377 A (MOTOROLA INC), 31. August 1999 (1999-08-31)

## Beschreibung

Die vorliegende Erfindung betrifft eine Anordnung zur Kompensation eines magnetischen Biasfeldes in einer Speicherschicht einer in einer Halbleitereinrichtung vorgesehenen magnetoresistiven Speicherzelle. Außerdem betrifft die Erfindung Verfahren zur Kompensation eines solchen Biasfeldes.

Eine auf dem Effekt der Magnetoresistanz basierende Speicherzelle wird üblicherweise durch einen Stapel aus zwei dünnen, ferromagnetischen Schichten mit einer dazwischen liegenden, mehrere Atomlagen mächtigen, nicht-ferromagnetischen Trennschicht realisiert.

Eine der beiden ferromagnetischen Schichten besteht aus einem hartmagnetischen Werkstoff, typischerweise aus einer Kobalt-Eisen-Legierung. Sie fungiert mit einer nach Betrag und Richtung konstanten Magnetisierung als Referenzschicht.

Die zweite ferromagnetische Schicht aus einem weichmagnetischem Werkstoff, typischerweise einer Nickel-EisenLegierung, bildet eine Speicherschicht. Die Ausrichtung ihrer Magnetisierung erfolgt korrespondierend zu einem Dateninhalt der Speicherzelle gleich- oder gegengerichtet der Magnetisierung der Referenzschicht.

Beim Schreiben eines Datums in die Speicherzelle bestimmt die Richtung eines Schreibstroms in einer Addressenleitung der Speicherzelle die Ausrichtung der Magnetisierung in der Speicherschicht bezüglich der Magnetisierung der Referenzschicht.

Der Werkstoff der Trennschicht ist bei einer auf einem Tunneleffekt beruhenden Konfiguration der Speicherzelle (MTJ, magnetic tunnel junction) ein Dielektrikum. In diesem Fall liegt dem Auslesen der Speicherzelle der Effekt zugrunde, dass die Häufigkeit von Übertritten von Elektronen durch die Trennschicht (Tunnelbarriere) bei gleicher Ausrichtung der Magnetisierung der beiden ferromagnetischen Schichten höher ist als bei entgegengesetzter Ausrichtung.

Der dem Auslesen der Speicherzelle zugrundeliegende Effekt beruht mithin auf internen Eigenschaften der magnetisierten ferromagnetischen Schichten, nicht aber auf einer unmittelbaren Wechselwirkung der von den beiden Schichten erzeugten Magnetfeldern. Deren Wechselwirkung, oder ferro- und antiferromagnetische Kopplung, beeinflusst das Betriebsverhalten der Speicherzelle.

Die ferromagnetische Kopplung bezeichnet dabei den Anteil der Wechselwirkung, der ein Ausrichten der Magnetisierung der Speicherschicht parallel zur Ausrichtung der Magnetisierung der Referenzschicht fördert und ein Umschalten der Magnetisierung der Speicherschicht in eine der Magnetisierung der Referenzschicht entgegengesetzten Richtung hemmt.

Entsprechend bezeichnet die antiferromagnetische Kopplung den Anteil der Wechselwirkung, der ein zur Ausrichtung der Magnetisierung der Referenzschicht paralleles Ausrichten der Speicherschicht hemmt und ein Umschalten der Magnetisierungsrichtung der Speicherschicht in einer der Magnetisierungsrichtung der Referenzschicht entgegengesetzten Richtung fördert.

Die Ferro- und antiferromagnetischen Kopplungen zwischen Referenz- und Speicherschicht ein- und derselben aber auch benachbarter Speicherzellen liefern Beiträge zu einem magnetischen Biasfeld innerhalb und außerhalb einer magnetoresistive Speicherzellen aufweisenden Halbleitereinrichtung. In einer von einem solchen Biasfeld durchdrungenen Speicherschicht bewirkt das Biasfeld eine Verschiebung der zum Umschalten der Magnetisierungsrichtung erforderlichen Feldstärken, den sogenannten Koerzitiv-Feldstärken. Diese Verschiebung erfordert eine Asymmetrie in den zu Schreiben erforderlichen Magnetfeldern und mithin auch den Schreibströmen.

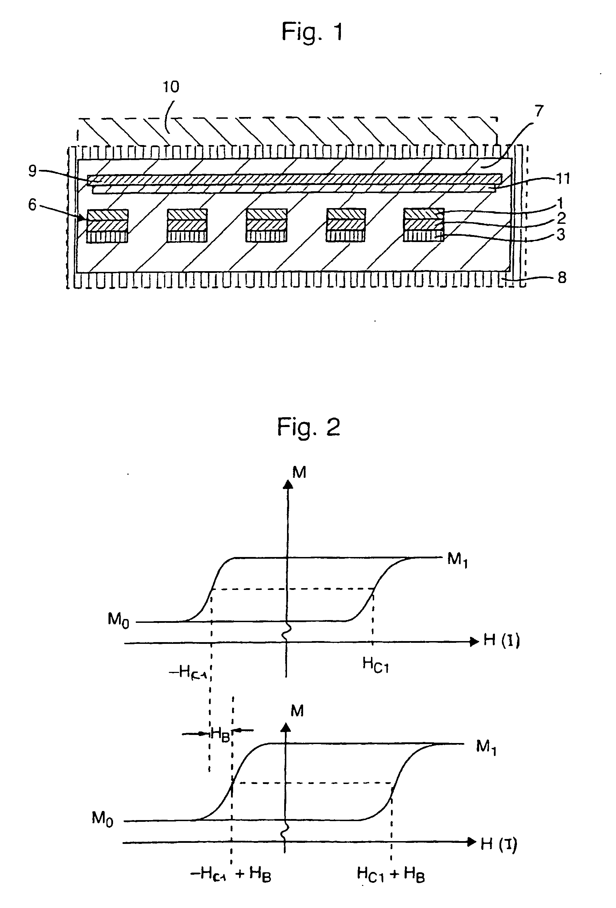

Dieser Effekt wird, zur Vereinfachung auf ein eindimensionales Umschalten der Speicherschicht reduziert, durch die beiden Zeichnungen der Fig. 2 verdeutlicht. Dabei bezeichnen H_{C1} und H_{C2} die Beträge der zum Umschalten der Magnetisierung zwischen den Zuständen M₀ und M₁ benötigten Koerzitiv-Feldstärken bei absenten Biasfeld und H_{B} den Betrag des magnetischen Biasfeldes.

Im oberen Teil der Fig. 2 ist die Ummagnetisierungskurve einer Speicherschicht für den Fall eines absenten Biasfeldes dargestellt. Die spezifischen Koerzitiv-Feldstärken H_{C1} und -H_{C1} liegen symmetrisch zur Magnetisierungsachse.

Im unteren Teil der Fig. 2 ist eine, auf ein durch den Schreibstrom I erzeugtes Magnetfeld H(I) bezogene Magnetisierungskurve bei Überlagerung mit einem entgegengesetzt der Magnetfeld-Achse wirkenden Biasfeld dargestellt. Für ein solches Magnetfeld erscheint die Magnetisierungskurve um den Betrag H_{B} entgegen der Richtung von H_{B} verschoben.

Sind das Biasfeld und die Magnetisierung der Speicherschicht gleich gerichtet, dann erfordert ein Umschalten der Magnetisierung ein magnetischen Feld, dessen Betrag sich aus der Summe der spezifischen Koerzitiv-Feldstärke der Speicherschicht und der magnetischen Feldstärke des Biasfeldes ergibt.

In diesem Fall reduziert das Biasfeld bei vorgegebenem, maximalem Schreibstrom Reserven hinsichtlich eines sicheren Umschaltens der Magnetisierung in der Speicherschicht der Speicherzelle.

Ist das Biasfeld der Magnetisierung der Speicherschicht entgegengerichtet, dann reicht zum Umschalten der Magnetisierung bereits ein magnetisches Feld mit einem Betrag aus, dem der um den Betrag der magnetischen Feldstärke des Biasfeldes verringerte Betrag der spezifischen Koerzitiv-Feldstärke der Speicherschicht entspricht.

In diesem Fall können bereits kleinere Magnetfelder ein Umschalten der Magnetisierung erzwingen. Damit ist eine Reserve gegenüber einem unerwünschtem Umschalten der Magnetisierung verringert. Solche Magnetfelder können ihre Ursache zum einen in extremen Störfeldern mit einer Quelle außerhalb der Halbleitereinrichtung haben. Eine zweite Quelle solcher Magnetfelder sind etwa von Schreibströmen benachbarter Speicherzellen innerhalb der Halbleitereinrichtung erzeugte Magnetfelder.

Die dem Biasfeld in der Speicherschicht zugrundeliegende ferromagnetische Kopplung wird durch den Abstand der beiden ferromagnetischen Schichten, der Dicke der Speicherschicht, sowie der Rauigkeit der die Speicherzelle bildenden Schichten bestimmt.

Dazu wird verwiesen auf: L. Néel, Comptes Rendus Acad. Sci. 255, 1676 (1962) und insbesondere Formel (1) in A. Anguelouch et al., Two-dimensional magnetic switching of micron-size films in magnetic tunnel junctions, Applied Physics Letters, Vol.76, Nr.5, 2000.

Die Ausrichtung des Biasfeldes erfolgt dabei nicht notwendigerweise in einer Richtung parallel zur Ausrichtung der durch die Schreibströme erzeugten Magnetfelder, sondern kann auch eine dazu orthogonale und zur Speicherschicht parallele Komponente aufweisen. Dazu wird insbesondere auf Fig. 2a in A. Anguelouch et al., Two-dimensional magnetic switching of micron-size films in magnetic tunnel junctions, Applied Physics Letters, Vol.76, Nr.5, 2000 verwiesen. Die physikalischen Ursachen für diesen Effekt sind nicht vollständig bekannt, jedoch ändert sich das Biasfeld nicht während einer Lebensdauer der Speicherzelle nach Betrag und Richtung.

Insbesondere die Rauigkeit der Schichten liefert variable und dabei schwer vorherbestimmbare Anteile zum Biasfeld. Der Beitrag der Rauigkeit variiert dabei zwischen aus verschiedenen Wafern gefertigten Halbleitereinrichtungen auch gleichen Designs, während er bei aus dem selben Wafer gefertigten Halbleitereinrichtungen ähnlich ist.

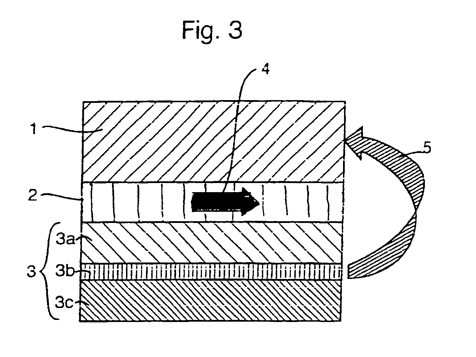

Fig. 3 stellt einen schematischen Querschnitt durch eine magnetoresistive Speicherzelle dar. Zwischen einer Referenzschicht 3 und einer Speicherschicht 1 liegt eine Trennschicht 2. Eine Aufteilung der Referenzschicht 3 in eine untere und eine obere Referenzteilschicht 3a, 3c mit einer nicht-magnetischen Zwischenschicht 3b erzeugt ein magnetisches Streufeld, das eine durch den Pfeil 5 angedeutete antiferromagnetische Kopplung erzeugen kann. Die Ursachen der ferromagnetischen Kopplung, also die Rauigkeit der Schichten, sowie die Mächtigkeit von Trennschicht und Speicherschicht werden durch den Pfeil 4 angedeutet.

Zur Verringerung des Biasfeldes wird gegenwärtig zum einen versucht, die ferromagnetische Kopplung zu reduzieren. Zum anderen wird versucht, die antiferromagnetische Kopplung auf eine Kompensation des Biasfeldes hin einzustellen.

Einer Verringerung der ferromagnetischen Kopplung durch eine dickere Speicherschicht stehen die dann erforderlichen, größeren Schaltströme zum Umschalten der Magnetisierung entgegen. Ebenso wird der Abstand der ferromagnetischen Schichten durch die Anforderungen an den elektrischen Widerstand der Speicherzelle und durch thermodynamische Erfordernisse vorgegeben.

Der Kompensation durch die antiferromagnetische Kopplung sind Grenzen gesetzt, da letztere nur bei niedrigen Nettomomenten ein stabiles Verhalten zeigt. Für einen maximalen Effekt müßte auf eine der Referenzteilschichten verzichtet werden, wodurch auch die Stabilität der Referenzschicht beeinträchtigt würde. Darüberhinaus lassen sich mit ihr keine etwa durch Magnetostriktion während eines Strukturierungsvorgangs der Speicherzelle oder der Halbleitereinrichtung hervorgerufene und zur Magnetisierungsrichtung der Speicherschicht gedrehte ferromagnetische Kopplung kompensieren. Ferner ist die antiferromagnetische Kopplung ungeeignet bei aus verschiedenen Wafern gefertigten Halbleitereinrichtungen regelmäßig voneinander abweichende Beiträge der durch die Rauigkeit der Schichten hervorgerufenen ferromagnetischen Kopplung zu kompensieren.

Es ist daher Aufgabe der Erfindung, eine Anordnung zur Verfügung zu stellen, die eine Kompensation eines Biasfeldes in der Speicherschicht einer in einer Halbleitereinrichtung vorgesehenen magnetoresistiven Speicherzelle ermöglicht und bei der die Geometrie der Speicherzelle unverändert bleibt. Außerdem sind Verfahren zur Verfügung zu stellen, mit der diese Kompensation erzielt werden kann.

Diese Aufgabe wird bei einer Anordnung der eingangs genannten Art erfindungsgemäß durch die im kennzeichnenden Teil des Patentanspruchs 1 angegebenen Merkmale gelöst. Die diese Aufgabe lösenden Verfahren sind in den Patentansprüchen 7 und 12 angegeben. Vorteilhafte Weiterbildungen der Erfindung ergeben sich jeweils aus den Unteransprüchen.
Bei einer Anordnung der erfindungsgemäßen Art wird also ein in einer Speicherschicht einer in einer Halbleitereinrichtung befindlichen magnetoresistiven Speicherzelle wirksames Biasfeld mittels eines magnetostatischen Streufeldes (im Folgenden Kompensationsfeld) mindestens einer in geeigneter Weise magnetisierten Kompensationsschicht kompensiert.

Die Kompensationsschicht kann außerhalb und/oder innerhalb der Halbleitereinrichtung aufgebracht sein.

Wird eine Kompensationsschicht innerhalb einer Halbleitereinrichtung aufgebracht, so geschieht dies vorzugsweise auf Wafer-Ebene mittels der zur Bearbeitung eines Wafers üblichen Technologien und mit den bei der Herstellung der Speicherzellen verwendeten Werkstoffen. Die magnetischen Eigenschaften einer solchen Kompensationsschicht können durch ein Strukturieren der Kompensationsschicht beeinflusst werden.

Innerhalb der Halbleitereinrichtung kann die Kompensationsschicht, etwa durch eine SiO₂-Schicht getrennt, unterhalb einer die Speicherzellen aufweisenden Speicherzellenschicht aufgebracht werden.

Bei Halbleitereinrichtungen mit mehreren Speicherzellenschichten kann jeder Speicherzellenschicht jeweils mindestens eine Kompensationsschicht zugeordnet werden, die auf die spezifischen Anforderungen der jeweiligen Speicherzellenschicht hin magnetisiert wird. Speicherzellen- und Kompensationsschichten wechseln sich in diesem Fall im Schichtaufbau der Halbleitereinrichtung ab.

In bevorzugter Weise wird die Kompensationsschicht innerhalb der Halbleitereinrichtung auf einer ersten, der Speicherzellenschicht folgenden Passivierung aufgebracht.

Wird die Kompensationsschicht während oder nach einem Häusen der Halbleitereinrichtung aufgebracht, so gilt sie in diesem Kontext als Kompensationsschicht außerhalb der Halbleitereinrichtung.

Eine solche Lösung ist das Verwenden von Gehäusen aus einem ferromagnetischen Werkstoff oder das Platzieren der Halbleitereinrichtung auf einem geeigneten Träger.

Eine bevorzugte Ausführungsform der erfindungsgemäßen Anordnung für eine außerhalb der Halbleitereinrichtung aufgebrachte Kompensationsschicht ist ein magnetisierbares Plättchen oder eine solche Folie, bevorzugt aufgebracht auf mindestens einer zur Speicherschicht parallelen Oberfläche der Halbleitereinrichtung. Von entscheidender Bedeutung ist dabei, dass mindestens eine Komponente des Magnetfeldes parallel zur Speicherschicht verläuft.

In jedem Fall kann auch eine für eine Abschirmung der Halbleitereinrichtung gegen äußere Felder vorgesehene Anordnung als Kompensationsschicht oder aber die Kompensationsschicht als Schirmung der Halbleitereinrichtung verwendet werden.

Um ein über alle Speicherzellen homogenes Kompensationsfeld zu erzeugen, wird die Kompensationsschicht bevorzugterweise über eine gesamte, zu den Speicherschichten parallele Querschnittsfläche der Halbleitereinrichtung aufgebracht.

Ein nachträgliches Strukturieren der Kompensationsschicht ermöglicht den Feinabgleich des Kompensationsfeldes. Vor einem Abgleich des Kompensationsfeldes ist es allerdings erforderlich, dieses zu bestimmen.

Das Ausmessen des Biasfeldes erfolgt in bevorzugter Weise in einem Testmode der Halbleiterinrichtung mittels einer Messvorrichtung. Die Messvorrichtung steuert dabei zwei zur Speicherschicht parallele und zueinander orthogonale magnetische Messfelder variabler Stärke. In deren Abhängigkeit wird ein Magnetfeld abhängiger, typischer Kennwert (im Folgenden Messgröße) der Speicherzelle, etwa ein elektrischer Widerstand der Speicherzelle ermittelt und an eine externe Prüfeinrichtung übertragen. Die Messfelder werden dabei in geeigneter Weise durch Ströme in für diesen Zweck besonders ausgeprägten Leiterbahnen der Halbleitereinrichtung oder unter Zuhilfenahme der vorhandenen Anschlussleitungen der Speicherzelle erzeugt.

Die betreffenden Leiterbahnen können wie auch eine Messstrecke zum Ausmessen der Messgröße an der Halbleitereinrichtung über Anschlüsse nach außen geführt sein. In diesem Fall erfolgt das Steuern der Messfelder und/oder das Ermitteln der Messgröße über eine Messvorrichtung außerhalb der Halbleitereinrichtung

In bevorzugter Weise wird die Messvorrichtung zumindest teilweise in die Halbleitereinrichtung integriert und weist jeweils mindestens eine steuerbare Stromquelle, zwei Dreieck-Generatoren und eine für die Messgröße geeignete Messeinrichtung auf. Von außen wird ein Messvorgang lediglich initiiert und danach die Messwerte für die Messgröße nach außen übertragen.

Die ausgemessene Speicherzelle kann dabei eine der funktionellen Speicherzelle der Halbleitereinrichtung, eine Referenzspeicherzelle oder eine eigens für dieses Verfahren vorgesehene Speicherzelle sein. Aus gewonnenen Daten wird das Kompensationsfeld nach Betrag und Richtung berechnet.

Die Kompensation des Biasfeldes erfolgt nach einem ersten erfindungsgemäßen Verfahren, indem eine bereits in oder auf der Halbleitereinrichtung aufgebrachte Kompensationsschicht nachträglich in Abhängigkeit von für das Biasfeld ausgemessenen Messwerten magnetisiert wird.

Die Magnetisierung der Kompensationsschicht erfolgt in einem äußeren Magnetfeld, dessen Stärke in Abhängigkeit der Neumagnetisierungskurve (Neukurve) des Werkstoffs der Kompensationsschicht in der spezifizierten Richtung und den für das Biasfeld ermittelten Werten eingestellt wird.

Die Kompensationsschicht besteht mindestens teilweise aus einem hartmagnetischen Werkstoff, der eine Vormagnetisierung aufweisen kann. Ein der Vormagnetisierung zugeordnetes Magnetfeld überlagert sich dem zu kompensierenden Biasfeld. Zudem folgt das Magnetisierungsverhalten der Kompensationsschicht nicht der Neukurve des Werkstoffs.

Im Falle einer bereits vormagnetisierten Kompensationsschicht wird also für die Feldstärke des die Kompensationsschicht magnetisierenden äußeren Magnetfeldes unter Umständen ein falscher Wert ermittelt. Das Kompensieren des Biasfeldes erfolgt dann unvollständig.

Daher wird in bevorzugter Weise das Biasfeld nach einer ersten gesteuerten Magnetisierung der Kompensationsschicht erneut ausgemessen. Aus den gewonnenen Messwerten kann auf Richtung und Betrag der Vormagnetisierung der Kompensationsschicht zurückgeschlossen werden. Es wird daraufhin ein neuer Wert für die Stärke und Richtung des die Magnetisierung der Kompensationsschicht steuernden äußeren Magnetfeldes ermittelt und mit einem solchen Magnetfeld die Kompensationsschicht erneut magnetisiert.

Bei diesem ersten erfindungsgemäßen Verfahren kann die Kompensationsschicht im Inneren der Halbleitereinrichtung oder außerhalb der Halbleitereinrichtung vorgesehen werden. Sie kann bei Bedarf zum Feinabgleich strukturiert werden.
Nach einem zweiten erfindungsgemäßen Verfahren wird zunächst das Biasfeld ausgemessen, bevor eine bereits passend magnetisierte Kompensationsschicht aufgetragen wird.

Das Biasfeld wird also bei absenter Kompensationsschicht und von einer solchen unverfälscht ausgemessen, wodurch das Verfahren zum Kompensieren des Biasfeldes vereinfacht wird. Das Kompensieren erfolgt dann auch bevorzugt in einer Stufe eines Fertigungsprozesses der Halbleitereinrichtung, der kein wesentlicher, die magnetischen Verhältnisse der Halbleitereinrichtung verändernder Heizschritt mehr folgt.

Anhand der übertragenen Messwerte wird eine nach Betrag und Richtung des Biasfeldes passende, vorbereitete Kompensationsschicht, in bevorzugter Weise eine präparierte Folie mit hartmagnetischen Abschnitten, auf der Halbleitereinrichtung aufgebracht.

Die präparierten Folien liegen dabei in einer ersten Variante in Form einer ersten, nach Betrag und Richtung der Magnetisierung sortierten Kollektion vor und werden mit einheitlicher Orientierung aufgebracht.

In einer zweiten Variante liegen die präparierten Folien als zweite, lediglich nach dem Betrag der Magnetisierung sortierten Kollektion vor und werden mit einer von der Richtung des Biasfeldes vorgegebenen Orientierung auf die Halbleitereinrichtung aufgebracht.

In besonders bevorzugter Weise weist die vorbereitete Kompensationsschicht, also auch die präparierte Folie, eine die Halbleitereinrichtung kennzeichnende Beschriftung auf.

Nachfolgend wird die Erfindung anhand der Zeichnungen näher erläutert, wobei für einander entsprechende Komponenten die gleichen Bezugszeichen verwendet werden. Es zeigen:
- Fig. 1: eine schematische Darstellung der Anordnung nach einem ersten und einem zweiten Ausführungsbeispiel der Erfindung,
- Fig. 2: eine vereinfachte Darstellung der Ummagnetisierungskurve einer Speicherschicht jeweils bei fehlendem Biasfeld und mit einem wirksamen Biasfeld und
- Fig. 3: eine schematische Darstellung einer magnetoresistiven Speicherzelle.

Die Fig. 2 und 3 wurden bereits eingangs erläutert.

Fig. 1 zeigt einen vereinfachten, nicht maßstabsgetreuen und auf die Darstellung der für die Erfindung wesentlichen Merkmale beschränkten Querschnitt durch eine Halbleitereinrichtung 7 mit magnetoresistiven Speicherzellen 6.

Die Speicherzellen 6 sind jeweils aus Speicher-, Trenn- und Referenzschicht 1,2,3 aufgebaut und im dargestellten Beispiel in einer einzigen Schicht der Halbleitereinrichtung 7 angeordnet. Parallel zu einer aus den Speicherzellen 6 gebildeten Speicherzellenschicht ist eine Passivierungsschicht 11 aufgebracht.

Durch ferromagnetische Kopplung zwischen den Referenz- und Speicherschichten 3,1 der Speicherzellen 6 entsteht ein magnetisches Biasfeld.

Für ein erstes Ausführungsbeispiel mit einer innerhalb der Halbleitereinrichtung 7 vorgesehenen Kompensationsschicht 9 entfallen die gestrichelt dargestellten Komponenten. Die Kompensationsschicht 9 ist im ersten Ausführungsbeispiel durch eine Passivierungsschicht 11 von den Speicherzellen 6 getrennt parallel zu den Speicherschichten 1 aufgebracht und kann so magnetisiert werden, dass das magnetische Feld der Magnetisierung das magnetische Biasfeld in den Speicherschichten 1 kompensiert. Um in allen Speicherschichten 1 der Halbleitereinrichtung 7 ein nach Betrag und Richtung möglichst gleiches, von der Magnetisierung der Kompensationsschicht 9 erzeugtes magnetische Feld zu erhalten, überdeckt die Kompensationsschicht 9 in bevorzugter Weise eine gesamte Querschnittsfläche der Halbleitereinrichtung 7.

Ein zweites Ausführungsbeispiel umfasst auch die gestrichelten Komponenten und weist eine außerhalb der Halbleitereinrichtung 7 vorgesehene Kompensationsschicht 10 und ein die Halbleitereinrichtung 7 mindestens teilweise umgebendes Gehäuse 8 auf, wobei die innerhalb der Halbleitereinrichtung 7 vorgesehene Kompensationsschicht 9 entfällt.

Auch die außerhalb der Halbleitereinrichtung aufgebrachte Kompensationsschicht 10 wird aus den oben genannten Gründen bevorzugt parallel zu den Speicherschichten 1 aufgebracht und bedeckt bevorzugterweise mindestens eine gesamte, zu den Speicherschichten 1 parallele Oberfläche.

### Bezugszeichenliste

- M: Magnetisierung
- H(I): magnetische Feldstärke eines durch einen Schreibstrom I erzeugten Magnetfeldes
- H_{C1}: Betrag einer spezifische Koerzitiv-Feldstärke
- M₀: erste Magnetisierung
- M₁: zweite Magnetisierung
- H_{B}: Betrag der magnetischen Feldstärke des Biasfelds
- 1: Speicherschicht
- 2: Trennschicht
- 3: Referenzschicht
- 3a: obere Referenzteilschicht
- 3b: Zwischenschicht
- 3c: untere Referenzteilschicht
- 4: Darstellung der ferromagnetischen Kopplung
- 5: Darstellung der antiferromagnetischen Kopplung
- 6: Speicherzelle
- 7: Halbleitereinrichtung
- 8: Gehäuse
- 9: Kompensationsschicht innerhalb der Halbleitereinrichtung
- 10: Kompensationsschicht außerhalb der Halbleitereinrichtung
- 11: Passivierungsschicht

## Patentansprüche

1. Anordnung zur Kompensation eines magnetischen Biasfeldes in einer Speicherschicht (1) von mindestens einer in einer Halbleitereinrichtung (7) vorgesehenen magnetoresistiven Speicherzelle (6),
**gekennzeichnet durch**
mindestens eine Kompensationsschicht (9/10), die mit einer das Biasfeld in der Speicherschicht (1) kompensierenden Magnetisierung versehen ist.

2. Anordnung nach Anspruch 1,
**dadurch gekennzeichnet,**
**dass** sich die Kompensationsschicht (9) innerhalb der Halbleitereinrichtung (7) befindet.

3. Anordnung nach Anspruch 1,
**dadurch gekennzeichnet,**
**dass** sich die Kompensationsschicht (10) außerhalb der Halbleitereinrichtung (7) befindet.

4. Anordnung nach Anspruch 2,
**dadurch gekennzeichnet,**
**dass** die Kompensationsschicht (9) durch wenigstens eine Isolationsschicht (11) von der Speicherzelle getrennt ist.

5. Anordnung nach einem der Ansprüche 1 bis 4,
**dadurch gekennzeichnet,**
**dass** das durch die Kompensationsschicht (9/10) erzeugte Magnetfeld parallel zur Speicherschicht (1) verläuft und sich dabei im Wesentlichen über die gesamte Querschnittsfläche der Halbleitereinrichtung (7) erstreckt.

6. Anordnung nach einem der Ansprüche 1 bis 5,
**dadurch gekennzeichnet,**
**dass** die Kompensationsschicht (9/10) für einen Feinabgleich strukturiert ist.

7. Verfahren zur Kompensation eines magnetischen Biasfeldes in einer Speicherschicht (1) einer in einer Halbleitereinrichtung (7) vorgesehenen magnetoresistiven Speicherzelle (6), umfassend die Schritte:
- Aufbringen einer ferromagnetischen Kompensationsschicht (9/10),
- Ausmessen des Biasfeldes nach Betrag und Richtung und
- Kompensieren des Biasfeldes durch Magnetisieren der Kompensationsschicht (9/10).

8. Verfahren nach Anspruch 7,
**dadurch gekennzeichnet,**
**dass** das Ausmessen und das Kompensieren des Biasfeldes mindestens einmal wiederholt wird, um eine in einer Vormagnetiesierung der Kompensationsschicht (9/10) begründete fehlerhafte Kompensation auszuschließen.

9. Verfahren nach einem der Ansprüch 7 oder 8,
**dadurch gekennzeichnet,**
**dass** die Kompensationsschicht (9) innerhalb der Halbleitereinrichtung (7) aufgebracht wird.

10. Verfahren nach einem der Ansprüch 7 oder 8
**dadurch gekennzeichnet,**
**dass** die Kompensationsschicht (10) außerhalb der Halbleitereinrichtung (7) aufgebracht wird.

11. Verfahren nach einem der Ansprüche 7 bis 10,
**dadurch gekennzeichnet,**
**dass** die Kompensationsschicht (9/10) strukturiert wird.

12. Verfahren zur Kompensation eines magnetischen Biasfeldes in einer Speicherschicht (3) einer in einer Halbleitereinrichtung (7) vorgesehenen magnetoresistiven Speicherzelle (6), umfassend die Schritte:
- Ausmessen des Biasfeldes nach Betrag und Richtung und
- Kompensieren des Biasfeldes durch Aufbringen einer Kompensationsschicht (10), die eine das Biasfeld in der Speicherschicht (3) kompensierende Magnetisierung aufweist.

13. Verfahren nach einem der Ansprüche 7 bis 12,
**dadurch gekennzeichnet,**
**dass** Messwerte einer den Betrag und die Richtung des magnetischen Biasfeldes kennzeichnenden Messgröße in einem Testmodus der Halbleitereinrichtung (7) von einer Messvorrichtung ermittelt und an eine Prüfapparatur übertragen werden.

14. Verfahren nach Anspruch 13,
**dadurch gekennzeichnet,**
**dass** die Messvorrichtung zwei zur Speicherschicht parallele und untereinander orthogonale Messströme steuert, die zwei zueinander orthogonale magnetische Messfelder erzeugen und dass für verschiedene Wertepaare der Messfelder mittels einer Messeinrichtung jeweils eine magnetfeldabhängige Kenngröße der Speicherzelle ermittelt wird.

15. Verfahren nach einem der Ansprüche 12 bis 14,
**dadurch gekennzeichnet,**
**dass** die Messvorrichtung mindestens teilweise innerhalb der Halbleitereinrichtung (7) vorgesehen wird.

16. Verfahren nach einem der Ansprüche 12 bis 15,
**dadurch gekennzeichnet,**
**dass** die Kompensationsschicht (10) als Folie aufgebracht wird, mit der die Halbleitereinrichtung (7) beschriftet wird.

## Claims

1. Arrangement for compensation of a magnetic bias field in a storage layer (1) of at least one magnetoresistive memory cell (6) provided in a semiconductor device (7),
**characterized by**
at least one compensation layer (9/10) which is provided with a magnetization that compensates for the bias field in the storage layer (1).

2. The arrangement according to Claim 1,
**characterized**
**in that** the compensation layer (9) is situated within the semiconductor device (7).

3. The arrangement according to claim 1,
**characterized**
**in that** the compensation layer (10) is situated outside the semiconductor device (7).

4. The arrangement according to Claim 2,
**characterized**
**in that** the compensation layer (9) is isolated from the memory cell by at least one insulation layer (11).

5. The arrangement according to one of Claims 1 to 4,
**characterized**
**in that** the magnetic field generated by the compensation layer (9/10) runs parallel to the storage layer (1) and in this case extends essentially over the entire cross-sectional area of the semiconductor device (7).

6. The arrangement according to one of Claims 1 to 5,
**characterized**
**in that** the compensation layer (9/10) is patterned for a fine adjustment.

7. Method for compensation of a magnetic bias field in a storage layer (1) of a magnetoresistive memory cell (6) provided in a semiconductor device (7), comprising the following steps:
- application of a ferromagnetic compensation layer (9/10),
- measurement of the bias field in terms of magnitude and direction, and
- compensation of the bias field by magnetization of the compensation layer (9/10).

8. The method according to Claim 7,
**characterized**
**in that** the measurement and the compensation of the bias field are repeated at least once in order to preclude an erroneous compensation due to a premagnetization of the compensation layer (9/10).

9. The method according to either of Claims 7 and 8,
**characterized**
**in that** the compensation layer (9) is applied within the semiconductor device (7).

10. The method according to either of Claims 7 and 8,
**characterized**
**in that** the compensation layer (10) is applied outside the semiconductor device (7).

11. The method according to one of Claims 7 to 10,
**characterized**
**in that** the compensation layer (9/10) is patterned.

12. Method for compensation of a magnetic bias field in a storage layer (3) of a magnetoresistive memory cell (6) provided in a semiconductor device (7), comprising the following steps:
- measurement of the bias field in terms of magnitude and direction, and
- compensation of the bias field by application of a compensation layer (10), which has a magnetization that compensates for the bias field in the storage layer (3).

13. The method according to one of Claims 7 to 12,
**characterized**
**in that** measured values of a measurement variable which characterizes the magnitude and the direction of the magnetic bias field are determined by a measuring apparatus in a test mode of the semiconductor device (7) and are transmitted to a test apparatus.

14. The method according to Claim 13,
**characterized**
**in that** the measuring apparatus controls two mutually orthogonal measurement currents parallel to the storage layer, which generate two magnetic measurement fields that are orthogonal to one another, and
**in that** a magnetic-field-dependent characteristic variable of the memory cell is in each case determined for different pairs of values of the measurement fields by means of a measuring device.

15. The method according to one of Claims 12 to 14,
**characterized**
**in that** the measuring apparatus is provided at least partially within the semiconductor device (7).

16. The method according to one of Claims 12 to 15,
**characterized**
**in that** the compensation layer (10) is applied as a film with which the semiconductor device (7) is inscribed.

## Revendications

1. Dispositif de compensation d'un champ magnétique polarisé dans une couche (1) de mémoire d'au moins une cellule (6) de mémoire magnétorésistante prévue dans un dispositif (7) à semi-conducteur,
**caractérisé par** au moins une couche (9/10) de compensation, qui est munie d'une aimantation compensant le champ polarisé dans la couche (1) de mémoire.

2. Dispositif suivant la revendication 1,
**caractérisé en ce que** la couche (9) de compensation se trouve à l'intérieur du dispositif (7) à semi-conducteur.

3. Dispositif suivant la revendication 1,
**caractérisé en ce que** la couche (9) de compensation se trouve à l'extérieur du dispositif (7) à semi-conducteur.

4. Dispositif suivant la revendication 2,
**caractérisé en ce que** la couche (9) de compensation est séparée de la cellule de mémoire par au moins une couche (11) isolante.

5. Dispositif suivant l'une des revendications 1 à 4,
**caractérisé en ce que** le champ magnétique produit par la couche (9/10) de compensation est parallèle à la couche (1) de mémoire et s'étend sensiblement sur toute la surface de la section transversale du dispositif (7) à semi-conducteur.

6. Dispositif suivant l'une des revendications 1 à 5,
**caractérisé en ce que** la couche (9/10) de compensation est structurée pour une égalisation fine.

7. Procédé de compensation d'un champ magnétique polarisé dans une couche (1) de mémoire d'une cellule (6) de mémoire magnétorésistante prévue dans un dispositif (7) à semi-conducteur comprenant les stades dans lesquels :
- on dépose une couche (9/10) ferromagnétique de compensation,
- on mesure le champ polarisé en valeur absolue et en direction et
- on compense le champ polarisé en aimantant la couche (9/10) de compensation.

8. Procédé suivant la revendication 7,
**caractérisé en ce que** l'on répète au moins une fois la mesure et la compensation du champ polarisé pour exclure une compensation erronée reposant sur une pré-aimantation de la couche (9/10) de compensation.

9. Procédé suivant l'une des revendications 7 ou 8,
**caractérisé en ce que** l'on dépose la couche (9) de compensation à l'intérieur du dispositif (7) à semi-conducteur.

10. Procédé suivant l'une des revendications 7 ou 8,
**caractérisé en ce que** l'on dépose la couche (9) de compensation à l'extérieur du dispositif (7) à semi-conducteur.

11. Procédé suivant l'une des revendications 7 à 10,
**caractérisé en ce que** l'on structure la couche (9/10) de compensation.

12. Procédé de compensation d'un champ magnétique polarisé dans une couche (3) de mémoire d'une cellule (6) de mémoire magnétorésistante prévue dans un dispositif (7) à semi-conducteur comprenant les stades dans lesquels :
- on mesure le champ polarisé en valeur absolue et en direction et
- on compense le champ polarisé par dépôt d'une couche (10) de compensation qui a une aimantation compensant le champ polarisé dans la couche (3) de mémoire.

13. Procédé suivant l'une des revendications 7 à 12,
**caractérisé en ce que** l'on détermine par un dispositif de mesure, dans un mode de test du dispositif (7) à semi-conducteur, des valeurs de mesure d'une grandeur de mesure caractérisant la valeur absolue et la direction du champ magnétique polarisé et on les transmet à un appareil de contrôle.

14. Procédé suivant la revendication 13,
**caractérisé en ce que** le dispositif de mesure commande deux courants de mesure parallèles à la couche de mémoire et orthogonaux entre eux qui produisent deux champs de mesure magnétiques orthogonaux l'un par rapport à l'autre, et **en ce que** l'on détermine pour des paires de valeurs différentes des champs de mesure, au moyen d'un dispositif de mesure, respectivement une grandeur de mesure de la cellule de mémoire, qui dépend du champ magnétique.

15. Procédé suivant l'une des revendications 12 à 14,
**caractérisé en ce que** l'on prévoit le dispositif de mesure au moins en partie à l'intérieur du dispositif (7) à semi-conducteur.

16. Procédé suivant l'une des revendications 12 à 15,
**caractérisé en ce que** l'on dépose la couche (10) de compensation sous la forme d'une feuille par laquelle on peut apposer des inscriptions sur le dispositif (7) à semi-conducteur.
